Europäisches Patentamt

European Patent Office

Office européen des brevets

(19)

(11) **EP 1 443 644 A2**

(12) **EUROPEAN PATENT APPLICATION**

(43) Date of publication:
**04.08.2004 Bulletin 2004/32**

(51) Int Cl.7: **H03H 11/04**

(21) Application number: **03103735.1**

(22) Date of filing: **08.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **08.10.2002 US 266809**

(71) Applicant: **TEXAS INSTRUMENTS INCORPORATED**
**Dallas, TX 75265 (US)**

(72) Inventors:
• **The inventor has agreed to waive his entitlement to designation.**

(74) Representative: **Holt, Michael et al**
**Texas Instruments Ltd.,**
**PO Box 5069**
**Northampton, Northamptonshire NN4 7ZE (GB)**

(54) **Simultaneous Gm-C filter and variable gain amplifier circuit**

(57) A system and method are provided for reducing the current consumption of receivers such as direct conversion receivers associated with modem receiver systems as well as low IF receiver systems, among others. The system and method dramatically reduce the current consumption in receivers due to three factors. 1) Since the filter 302 also performs the VGA function, the current consumption of the VGA 304 is eliminated; 2) Since the gain partitioning of the structure 200 depicted in Figure 2 is superior, the noise performance of the filter 302 is greatly reduced; and the base band LNA 304 can be eliminated, also eliminating the current consumption of the base band LNA 304; and 3) The folded $g_m$ structure 500 depicted in Figure 5 can be used, cutting the current consumption of the base band filter 302 by a factor of two. The structure 200 notably does require control circuitry to set the $g_m$ values of the forward and feedback paths independently. The current consumption of this control circuitry however, is far less than the current saved due to the three factors discussed herein above. The base band circuitry current consumption can be reduced by about a factor or three by implementing the structure 200.

FIG. 2

EP 1 443 644 A2

Printed by Jouve, 75001 PARIS (FR)

**Description**

Background of the Invention

Field of the Invention

This invention relates generally to receiver systems, and more particularly to a system and method for reducing current consumption of direct conversion receivers and low IF receiver systems, among other things.

Description of the Prior Art

Direct conversion receivers are gaining in popularity in modem receiver systems, especially for cellular phone applications. This structure has the advantage of not requiring any IF filters and reducing the number of down-conversions required. This advantageously minimizes cost, reduces PC board area and reduces die size. The current consumption of direct conversion receivers however, has typically been higher than that seen with heterodyne systems. This has hurt the competitiveness of direct conversion systems. Most of the additional current consumption is associated with the base band circuitry of a direct conversion receiver.

In view of the foregoing discussion, a need exists for a system and method for reducing the current consumption of receiver systems such as direct conversion receivers and low IF receiver systems, among others.

Summary of the Invention

The present invention is directed to a system and method for reducing the current consumption associated with modem receiver systems, such as direct conversion receivers and low IF receiver systems, among other things.

The present invention provides various technical advantages. Since the base band system filter also performs the variable gain amplification (VGA) function, the current consumption of the VGA is eliminated. Further, since the gain partitioning of the filter structure is superior, the noise performance of the filter is greatly reduced; and the base band front end low noise amplifier (LNA) can be eliminated, also eliminating the current consumption of the base band LNA. A folded $g_m$ structure can be used to implement the filter $g_m$ stages, substantially cutting the current consumption of the base band filter by a factor of two.

According to one embodiment of the invention, a receiver base band system comprises a Gm-C filter having a plurality of $g_m$ stages configured to provide an automatic gain control (AGC) function.

According to another embodiment of the invention, a receiver base band system comprises a filter having a plurality of current folded $g_m$ cells configured to provide a variable gain amplification (VGA) function.

According to yet another embodiment of the invention, a receiver base band system comprises base band circuitry having base band filtering means for providing variable gain amplification of base band filter input signals.

According to still another embodiment of the invention, a method of reducing current consumption of a receiver base band system comprises the steps of providing a base band Gm-C filter having $g_m$ cells configured to provide mismatched forward and reverse $g_m$ values, and further configured to provide an AGC function; filtering an input signal via the base band Gm-C filter to provide a base band filtered output signal; and controlling $g_m$ values associated with the Gm-C filter to variably amplify the filtered output signal.

Brief Description of the Drawings

Other aspects and features of the present invention and many of the attendant advantages of the present invention will be readily appreciated as the same become better understood by reference to the following detailed description when considered in connection with the accompanying drawings in which like reference numerals designate like parts throughout the figures thereof and wherein:

Figure 1 illustrates a generalized ladder structure familiar to those skilled in the filter synthesis art;

Figure 2 illustrates a Gm-C filter with AGC function according to one embodiment of the present invention;

Figure 3 is a simple block diagram illustrating one known base band architecture that employs a low-pass filter implemented as a unity gain $g_m$-C filter having a plurality of $g_m$ stages;

Figure 4 is a schematic diagram illustrating a conventional $g_m$ structure suitable for use in each of the $g_m$ stages employed by the low-pass filter shown in Figure 3 in which the $g_m$ of the forward and feedback paths are matched;

Figure 5 is a schematic diagram illustrating a folded $g_m$ structure according to one embodiment of the present invention that is suitable for use in each of the $g_m$ stages employed by the low-pass filter shown in Figure 3 in which the $g_m$ of the forward and feedback paths are not the same; and

Figure 6 shows a simulated frequency response at various gain settings for a base band architecture that employs the Gm-C filter with AGC function shown in Figure 2.

While the above-identified drawing figures set forth alternative embodiments, other embodiments of the present invention are also contemplated, as noted in the discussion. In all cases, this disclosure presents illustrated embodiments of the present invention by way of representation and not limitation. Numerous other modifications and embodiments can be devised by those skilled in the art which fall within the scope and spirit of the principles of this invention.

Detailed Description of the Preferred Embodiments

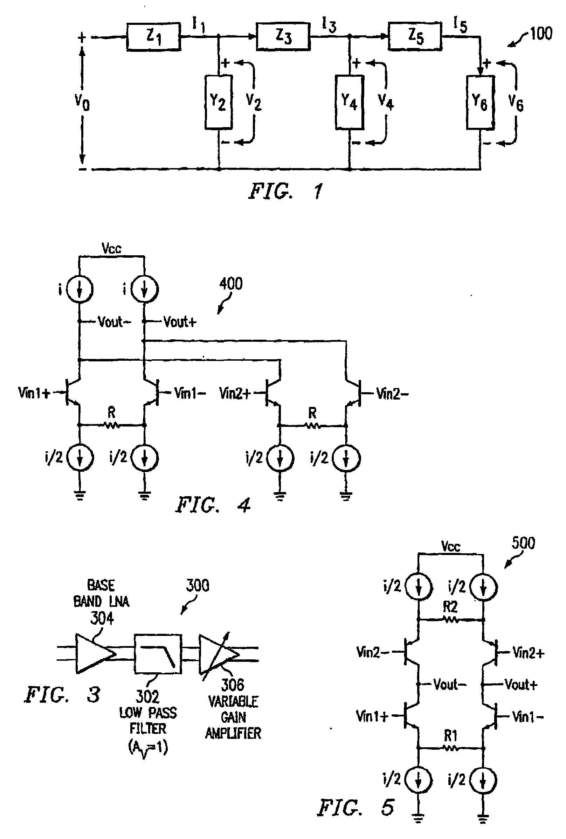

Table 1 shows the current consumption associated with the base band portion of one known direct conversion receiver architecture suitable for WCDMA applications. A system and method of significantly reducing this current consumption according to particular embodiments of the present invention are described herein below with reference to Figures 1-5. The present invention is not so limited however, and it shall be understood that the techniques presented herein can just as easily be employed to reduce the current consumption of low IF receiver systems, among others.

TABLE 1

| Current Consumption of Base band Portion of Direct Conversion Receiver | |
| --- | --- |
| Base band LNAs | 3.1 mA |
| IF Filters | 6.7 mA |
| Base band AGCs | 6.9 mA |
| Total | 16.7 mA |

The particular embodiments of the present invention described herein specifically reduce the current consumption of the base band circuitry associated with a direct conversion receiver by combining the receiver filtering and AGC functions into one circuit. This technique provides several advantages in circuit performance as discussed herein below.

The embodiments are best understood by first setting forth the theory behind the particular embodiments as presented below. Consider first, the generalized ladder structure 100 shown in Figure 1. The currents and voltages within the structure 100 can be expressed as:

$$I_1 = \frac{V_0 - V_2}{Z_1} \tag{1}$$

$$V_2 = \frac{I_1 - I_3}{Y_2} \tag{2}$$

$$I_1 = \frac{V_2 - V_4}{Z_3} \tag{3}$$

$$V_4 = \frac{I_3 - I_5}{Y_4} \tag{4}$$

$$I_5 = \frac{V_4 - V_6}{Z_5} \tag{5}$$

$$V_6 = \frac{I_5}{Y_6} \tag{6}$$

In order to synthesize a circuit that will produce the same frequency response as that shown in Figure 1, and also allow for an AGC function, it is desirable to create a circuit having signals that are proportional to the voltages and currents given in Equations 1 through 6 above. To this end, a new set of voltages, $V_1'....V_6'$, can be defined as

$$V_1' = a_1 \frac{I_1}{g_m} \tag{7}$$

$$V_{2'} = a_1 a_2 V_2 \tag{8}$$

$$V_3' = a_1 a_2 a_3 \frac{I_3}{g_m} \tag{9}$$

$$V_4' = a_1 a_2 a_3 a_4 V_4 \tag{10}$$

$$V_5' = a_1 a_2 a_3 a_4 a_5 \frac{I_5}{g_m} \tag{11}$$

$$V_6' = a_1 a_2 a_3 a_4 a_5 a_6 V_6 \tag{12}$$

If a circuit can be synthesized to create the voltages defined by Equations 7 though 12, then the voltage $V_6'$ will have the same frequency response as the ladder network 100 depicted in Figure 1, and will also have an additional voltage gain given by the product of $a_1$ through $a_6$ as seen by equation 12. This circuit synthesis can be achieved by first combining equations 1 through 6 with Equations 7 through 12 respectively, to yield equations 13 through 18 below.

$$V_1' = \frac{a_1}{g_m} \frac{V_0 - V_2}{Z_1} \tag{13}$$

$$V_2' = a_1 a_2 \frac{I_1 - I_3}{Y_2} \tag{14}$$

$$V_3' = \frac{a_1 a_2 a_3}{g_m} \frac{V_2 - V_4}{Z_3} \tag{15}$$

$$V_4' = a_1 a_2 a_3 a_4 \frac{I_3 - I_5}{Y_4} \tag{16}$$

$$V_5' = \frac{a_1 a_2 a_3 a_4 a_5}{g_m} \frac{V_4 - V_6}{Z_5} \tag{17}$$

$$V_6' = a_1 a_2 a_3 a_4 a_5 a_6 \frac{I_5}{Y_6} \tag{18}$$

Equations 13 through 18 are next combined to create equations 19 through 24 below.

$$V_1' = \frac{g_m V_0 a_1 - g_m V_2'/a_2}{g_m{}^2 Z_1} \tag{19}$$

$$V_2' = \frac{g_m V_1' a_2 - g_m V_3'/a_3}{Y_2} \tag{20}$$

$$V_3' = \frac{g_m V_2' a_3 - g_m V_4'/a_4}{g_m{}^2 Z_3} \tag{21}$$

$$V_4' = \frac{g_m V_3' a_4 - g_m V_5'/a_5}{Y_4} \tag{22}$$

$$V_5' = \frac{g_m V_4' a_5 - g_m V_6'/a_6}{g_m{}^2 Z_5} \tag{23}$$

$$V_6' = \frac{g_m V_5' a_6}{Y_6} \tag{24}$$

By creating a circuit that synthesizes Equations 19 through 24, one can now provide a circuit that has the desired frequency response and that is also capable of performing the desired AGC function by varying the values of $a_1$ through $a_6$. The present inventor found that such a circuit could be implemented using the Gm-C structure 200 shown in Figure 2 that illustrates a Gm-C filter with AGC function according to one embodiment of the present invention. The use of the circuit structure 200 shown in Figure 2 has several advantages. One of the most significant advantages is that the gain and filtering are apportioned much better than that achievable using more conventional circuit structures.

Figure 3 is a simple block diagram illustrating one known base band architecture 300 that employs a low-pass filter 302 implemented as a unity gain $g_m$-C filter having a plurality of $g_m$ stages. The present inventor realized that each of the $g_m$ stages within the filter 302 contribute roughly an equal amount to the input noise voltage. A base band LNA 304 was added to overcome this noise. The gain of the base band LNA 304 however, increases the linearity requirements on the filter 302 and VGA 306. The base-band LNA 304 is no longer required for the circuit 200 depicted in Figure 2 since at maximum gain, where the noise performance is most critical, all of the stages have significant gain and the stages after the first $g_m$ stage contribute a relatively minor amount to the input noise voltage. Eliminating the base band LNA 304 was found by the present inventor to have two advantages. First, the current consumption of the base band LNA 304 is eliminated; and second, the linearity requirement on the gm-C filter 302 is reduced.

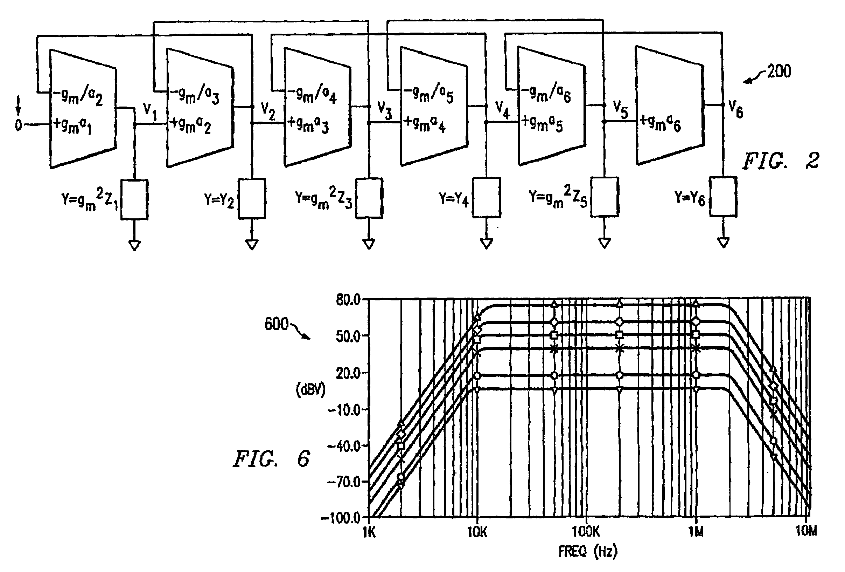

The present inventor also realized a further current consumption savings could be achieved by using the current folded structure 500 shown in Figure 5 for each $g_m$ cell discussed herein before. Those skilled in the filter synthesis art will readily appreciate the $g_m$ of the forward and feedback paths for a conventional unity gain $g_m$-C filter must match. Thus, a conventional $g_m$ structure 400 shown in Figure 4 can be employed. Since the $g_m$ cells shown in Figure 2 have forward and reverse $g_m$ values that are not the same, it can be appreciated that the forward and feedback $g_m$'s need not match. This allows the current consumption of the gm-C filter 302 to be cut in half.

In summary explanation of the above, the structure 200 depicted in Figure 2 can be used to dramatically reduce the current consumption in direct conversion receivers due to three factors. 1) Since the filter 302 also performs the VGA function, the current consumption of the VGA 304 is eliminated; 2) Since the gain partitioning of the structure 200 depicted in Figure 2 is superior, the noise performance of the filter 302 is greatly reduced and the base band LNA 304 can be eliminated also eliminating the current consumption of the base band LNA 304; and 3) The folded $g_m$ structure 500 depicted in Figure 5 can be used, cutting the current consumption of the base band filter by a factor of two. The structure 200 shown in Figure 2 notably does require control circuitry to set the $g_m$ values of the forward and feedback paths independently. Details of this control circuitry are not discussed herein to preserve clarity and brevity, and since those skilled in the direct conversion receiver system art will readily be able to employ a large variety of techniques to implement the control circuitry. The current consumption of this control circuitry however, will be substantially less than the current saved due to the three factors discussed herein above. The present inventor found that the base band circuitry current consumption (16.7 mA) shown in Table 1 could be reduced by about a factor or three to 5.5 mA, by implementing the structure 200 shown in Figure 2.

Figure 6 shows a simulated frequency response 600 at various gain settings for a base band architecture that employs the Gm-C filter with AGC function shown in Figure 2. The highpass portion of the response 600 was implemented for DC offset correction and is not associated with the embodiments discussed herein above. The low-pass portion of the response 600 is associated with the structure 200 depicted in Figure 2. Further, the simulated noise performance of the Gm-C filter at maximum gain was found to be 6.2 nV/sqrt(Hz) as compared with 7 nV/sqrt(Hz) for the structure 400 shown in Figure 4. Finally, the linearity of a base band architecture that employs the Gm-C filter with AGC function shown in Figure 2 was also better than that achievable when using the more conventional base band architecture, providing an output compression point of 1.15 Vp-p as compared to 0.8 Vp-p respectively.

This invention has been described in considerable detail in order to provide those skilled in the direct conversion receiver art with the information need to apply the novel principles and to construct and use such specialized components as are required. In view of the foregoing descriptions, it should be apparent that the present invention represents a significant departure from the prior art in construction and operation. However, while particular embodiments of the present invention have been described herein in detail, it is to be understood that various alterations, modifications and substitutions can be made therein without departing in any way from the spirit and scope of the present invention, as defined in the claims which follow. The techniques discussed herein before, can for example, just as well be applied to reduce current consumption of low IF receiver systems, among others.

**Claims**

1. A receiver base band system comprising a Gm-C filter having a plurality of $g_m$ stages configured to provide an automatic gain control (AGC) function.

2. The receiver base band system according to claim 1 wherein each $g_m$ stage comprises at least one $g_m$ cell configured as a current folded structure.

3. The receiver base band system according to claim 1 wherein each $g_m$ stage comprises at least one current folded structure configured with mismatched forward and feedback $g_m$ cells.

4. A receiver base band system comprising a filter having a plurality of current folded $g_m$ cells configured to provide a variable gain amplification (VGA) function.

5. The receiver base band system according to claim 4 wherein the plurality of current folded $g_m$ cells form a plurality of $g_m$ stages configured with mismatched forward and feedback $g_m$ cells.

6. A receiver base band system comprising base band circuitry having base band filtering means for providing variable gain amplification of base band filter input signals.

7. The receiver base band system according to claim 6 wherein the filtering means comprises a plurality of current folded $g_m$ cells.

8. The receiver base band system according to claim 7 wherein the plurality of current folded $g_m$ cells form a plurality of $g_m$ stages configured with mismatched forward and feedback $g_m$ cells.

9. The receiver base band system according to claims 1, 4, or 8 wherein the base band system is devoid of any base band low noise amplifier (LNA).

10. A method of reducing current consumption of a receiver base band system, the method comprising the steps of:

   providing a base band Gm-C filter having $g_m$ cells configured to provide mismatched forward and reverse $g_m$ values, and further configured to provide an AGC function;
   filtering an input signal via the base band Gm-C filter to provide a base band filtered output signal; and
   controlling $g_m$ values associated with the Gm-C filter to variably amplify the filtered output signal.

EP 1 443 644 A2

FIG. 1

FIG. 4

FIG. 3

FIG. 5

FIG. 2

FIG. 6

EP 1 443 644 A2